(19) Europäisches Patentamt
European Patent Office
Office européen des brevets

(11) Publication number: 0 277 034 A2

# (12) EUROPEAN PATENT APPLICATION

(21) Application number: 88300784.1

(22) Date of filing: 29.01.88

(51) Int. Cl.4: B 32 B 17/10

(30) Priority: 29.01.87 US 8709

(43) Date of publication of application: 03.08.88 Bulletin 88/31

(84) Designated Contracting States: BE DE FR GB IT NL SE

(71) Applicant: THE MEAD CORPORATION
Mead World Headquarters Courthouse Plaza Northeast
Dayton Ohio 45463 (US)

(72) Inventor: Gottschalk, Peter
71 Gershwin Drive
Centerville Ohio 45459 (US)

(74) Representative: Deans, Michael John Percy et al
Lloyd Wise, Tregear & CO. Norman House 105-109 Strand
London WC2R OAE (GB)

## (54) Lamination of two substrates.

(57) A process is described for laminating two substrates or at least one of which should be transparent or translucent. A photohardenable composition is coated on one surface of a first substrate. The photohardenable composition comprises a free radical addition polymerizable or crosslinkable compound and a dye-counter ion complex, the complex being capable of absorbing actinic radiation and producing free radicals which initiate free radical polymerization or crosslinking of the compound, and preferably being photobleachable. A second substrate is applied to the photo- hardenable composition such that the photohardenable composition is interposed between the first and second substrate. The substrates are then exposed to actinic radiation.

EP 0 277 034 A2

## Description

### LAMINATION OF TWO SUBSTRATES

The present invention relates to a process for laminating two substrates.

Current photo lamination techniques for glass and similar substrates involve bonding thin translucent layers together with a thermally cured adhesive. Photocrosslinkable and photopolymerizable adhesives have not been used extensively because the adhesives which have been available commercially employ UV initiators. Glass and plastic substrates tend to absorb heavily in the UV range making it impractical to use most UV sensitive adhesives.

We have found that dye-counter ion complexes are useful visible light initiators for free radical addition reactions, and that an adhesive which comprises a free radical addition polymerizable or cross-linkable composition containing a dye-counter ion complex capable of absorbing actinic radiation and producing free radicals provides a means of eliminating the disadvantages of ultraviolet and thermal initiators in laminating glass and similar substrates.

Dye-counter ion complexes provide a means for generating free radicals from the singlet state of an excited dye, and in so doing, we have found that they enable the provision of visible light hardenable compositions which are useful as adhesives in laminating two or more transparent or translucent substrates together or a transparent or translucent substrate and an opaque substrate.

In accordance with a first aspect of the present invention, there is provided a process for laminating two substrates which comprises the steps of:

coating a photohardenable composition on one surface of a first substrate, said photohardenable composition comprising a free radical addition polymerizable or crosslinkable compound and a dye-counter ion complex, said complex being capable of absorbing actinic radiation and producing free radicals which initiate free radical polymerization or crosslinking of said compound;

applying a second substrate to said photohardenable composition to form a laminate in which said photohardenable composition is interposed between said first and said second substrate; and

exposing said laminate to actinic radiation; at least one of said substrates being transparent or translucent.

According to a second and alternative aspect of the present invention, there is provided a process for laminating two substrates which comprises the steps of:

coating a photohardenable composition on one surface of a first substrate, said photohardenable composition comprising a free radical addition polymerizable or crosslinkable compound and a dye-counter ion complex, said complex being capable of absorbing actinic radiation and producing free radicals which initiate free radical polymerization or crosslinking of said compound;

applying a second substrate to said photohardenable composition such that said photohardenable composition is interposed between said first substrate and said second substrate; and

exposing said substrates to actinic radiation; wherein at least one of said substrates is glass.

A particular advantage of using dye-counter ion complexes as initiators of free radical addition reactions for adhesives for glass lamination is the ability to select from a wide variety of dyes which absorb at substantially differenty wavelengths. The absorption characteristics of the complex are principally determined by the dye. Thus, by selecting a dye which absorbs at 400 nm or greater, the sensitivity of the photosensitive material can be extended well into the visible range and by selecting a dye which is bleached upon exposure a laminate can be obtained which is essentially as transparent as the substrate lamina.

In preferred embodiments, the dye complex is a cationic dye-borate anion complex or an anionic dye-counter ion complex. Particular preferred examples of these dye complexes are a cyanine dye-borate anion complex and an anionic dye complex such as complexes of xanthene dyes with iodonium or phosphonium ions.

Processes in accordance with the present invention are useful for laminating transparent or translucent substrates. Examples of useful substrates include glass and transparent or translucent polymeric films such as polyethylene terephthalate films, polycarbonate, mylar film or laminates of protective films and glass. Processes in accordance with the present invention are particularly useful in laminating window glass and plate glass.

Ionic dye-counter ion complexes useful in the present invention are described in European Patent Application No. 86308967.8 filed 18 November, 1986, (Publication No. ), the disclosure of which is to be regarded as incorporated herein by reference.

Such compounds consist of a visible light absorber (the ionic dye) ionically bonded to a reactive counter ion. The counter ion is reactive in the sense that upon excitation of the dye the counter ion donates an electron to or accepts an electron from the excited dye. This electron transfer process generates radicals capable of initiating polymerization of a monomer.

The ionic compounds used in the present invention are different than the collision generated species encountered in other photosensitive systems such as collision complexes which yield encounter complexes, exciplexes and/or contact ion pairs. See for example, Kavarnos, George J. and Turro, Nicholas J., "Photosensitization by Reversible Electron Transfer", Chem. Rev. 1986, 401-449.

In accordance with the present invention the ionic dye and the counter ion are present in the photopolymerizable composition as a stable, non-transient compound, and not as a dissociated ion pair.

Formation of the compound is not dependent upon diffusion and collision. As distinguished from photographic materials and compositions containing collision dependent complexes essentially all of the sensitizing dye present in the photosensitive materials of the present invention prior to exposure is ionically bonded to the the counter ion.

The ionic compounds used as initiators are typically soluble in nonpolar solvents such as TMPTA and the like. They are soluble in an amount of at least about 0.1.% and preferably at least about 0.3% by weight. While these amounts are not large, they are substantial considering the normally lower solublity of ionic materials in polar solvents. While the compounds are soluble, the dye and the counter ion do not dissociate in solution. They remain ionically bonded to each other.

In dye-sensitized photopolymerizable compositions, visible light is absorbed by a dye having a comparable absorption band, the dye is raised to its excited electronic state, the lifetime of which may be $10^{-9}$ to $10^{-3}$ second, depending upon the nature (singlet or triplet) of the excited state. During this time, absorbed energy can be utilized to promote electron transfer to or from the dye molecule to produce the free radical. In prior initiator systems, this transfer is diffusion controlled. The excited dye must interact (collide) with another molecule in the composition which quenches the dye and generates a free radical. In the present invention, the transfer is not diffusion (collision) controlled. Electron transfer occurs at greater than diffusion controlled rates. In terms of Stern-Volmer kinetics, this means the quenching constant (Kq) of the excited dye is greater than $10^{10}$ and, more particularly, greater than $10^{12}$. At these rates, electron transfer can occur through the singlet state.

By generating free radicals from the excited state of an ionic dye in this way enables provision of photo hardenable compositions which are sensitive at longer wavelengths.

One of the particular advantages of using ionic dye-counter ion compounds as initiators of free radical addition reactions is the ability to select from a wide variety of dyes which absorb at substantially different wavelengths. The absorption characteristics of the compound are principally determined by the dye. Thus, by selecting a dye which absorbs at 400 nm or greater, the sensitivity of the photosensitive material can be extended well into the visible range.

Cationic dye-borate anion compounds are known in the art. Their preparation and use in imaging systems is described in U.S. Patents 3,567,453; 4,307,182; 4,343.891; 4,447,521; and 4,450,227.

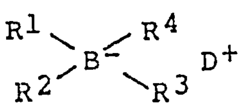 (I)

where D+ is a cationic dye; and $R^1$, $R^2$, $R^3$, and $R^4$ are independently selected from alkyl, aryl, alkaryl, allyl, aralkyl, alkenyl, alkynyl, alicyclic and saturated unsaturated heterocyclic groups.

Useful dyes form photoreducible but dark stable complexes with borate anions and can be cationic methine, polymethine, triarylmethane, indoline, thiazine, xanthene, oxazine and acridine dyes. More specifically, the dyes may be cationic cyanine, carbocyanine, hemicyanine, rhodamine and azomethine dyes. In addition to being cationic, the dyes are preferably photobleachable. Furthermore, the dyes should not contain groups which would neutralize or desensitize the complex or render the complex poorly dark stable. Examples of groups which generally should not be present in the dye are acid groups such as free carboxylic or sulphonic acid groups.

Specific examples of useful cationic dyes are Methylene Blue, Safranine O, Malachite Green, cyanine dyes of the general formula (II) and rhodamine dyes of the formula (III):

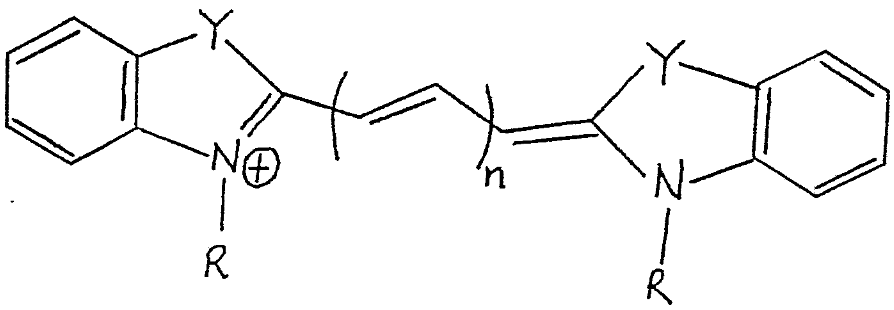

(II)

n = 0, 1, 2, 3,
R = alkyl
Y = CH=CH, $N-CH_3$, $C(CH_3)_2$, O, S, Se

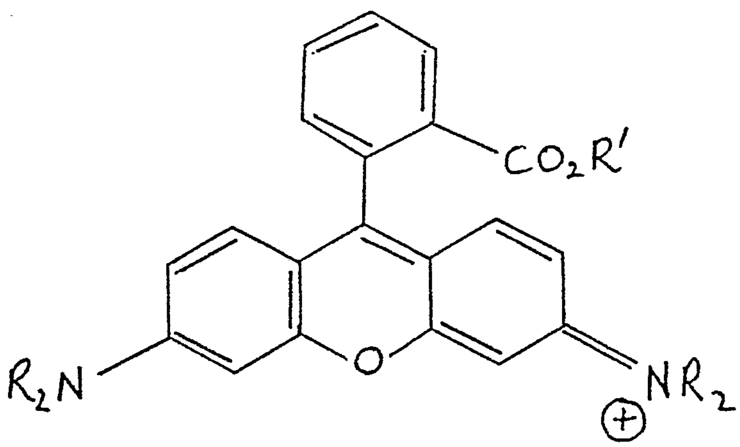

(III)

R', R = alkyl; aryl, and any combination thereof

While they have not been tested, the cationic cyanine dyes disclosed in U.S. Patent 3,495,987 should be useful in the present invention.

The borate anion is designed such that the borate radical generated upon exposure to light and after electron transfer to the dye (Eq. 1) readily dissociates with the formation of a radical as follows:

$$BR_4^{\cdot} \longrightarrow BR_3 + R^{\cdot} \qquad \text{(Eq. 2)}$$

For example particularly preferred anions are triphenylbutylborate and trianisylbutylborate anions because they readily dissociate to triphenylborane or trianisylborane and a butyl radical.

Preferably, at least one but not more than three of $R^1$, $R^2$, $R^3$, and $R^4$ is an alkyl group. Each of $R^1$, $R^2$, $R^3$, and $R^4$ can contain up to 20 carbon atoms, and they typically contain 1 to 7 carbon atoms. More preferably $R^1$-$R^4$ are a combination of alkyl group(s) and aryl group(s) or aralkyl group(s) and still more preferably a combination of three aryl groups and one alkyl group.

Representative examples of alkyl groups represented by $R^1$-$R^4$ are methyl, ethyl, propyl, butyl, pentyl, hexyl, octyl, stearyl, etc. The alkyl groups may be substituted, for example, by one or more halogen, cyano, acyloxy, acyl, alkoxy or hydroxy groups.

Representative examples of aryl groups represented by $R^1$-$R^4$ include phenyl, naphthyl and substituted aryl groups such as anisyl. Alkaryl groups include methylphenyl, dimethylphenyl, etc. Representative examples of aralkyl groups represented by $R^1$-$R^4$ groups include benzyl. Representative alicyclic groups include cyclobutyl, cyclopentyl, and cyclohexyl groups. Examples of an alkynyl group are propynyl and ethynyl, and examples of alkenyl groups include a vinyl group.

As a general rule, useful ionic dye compounds must be identified empirically, however, potentially useful dye and counter ion combinations can be identified by reference to the Weller equation (Rehm, D. and Weller, A., Isr. J Chem. (1970), 8, 259-271), which can be simplified as follows.

$$\Delta G = E_{ox} - E_{red} - E_{h\nu} \qquad \text{(Eq. 3)}$$

where $\Delta$ G is the change in the Gibbs free energy, $E_{ox}$ is the oxidation potential of the borate anion BR , $E_{red}$ is the reduction potential of the cationic dye, and $E_{h\nu}$ is the energy of light used to excite the dye. Useful compounds will have a negative free energy change. Similarly, the difference between the reduction potential of the dye and the oxidation potential of the borate must be negative for the compounds to be dark stable, i.e., Eox - Ered $>$ 0.

As indicated, Eq. 2 is a simplification and it does not absolutely predict whether a compound will be useful in the present invention or not. There are a number of other factors which will influence this determination. One such factor is the effect of the monomer on the compound. Another factor is the radial distance between the ions. It is also known that if the Weller equation produces too negative a value, deviations from the equation are possible. Furthermore, the Weller equation only predicts electron transfer, it does not predict whether a particular compound is an efficient initiator of polymerization. The equation is a useful first approximation.

Specific examples of cationic dye-borate anion compounds useful in the present invention are shown in the following table with their $\lambda$ max.

Table

| Compound No. | Structure | λmax (TMPTA) |
|---|---|---|
| 1. | 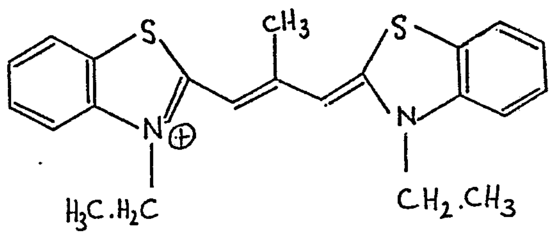 $Ph_3B^{\ominus}n-C_4H_9$ | 552 nm |
| 2. | 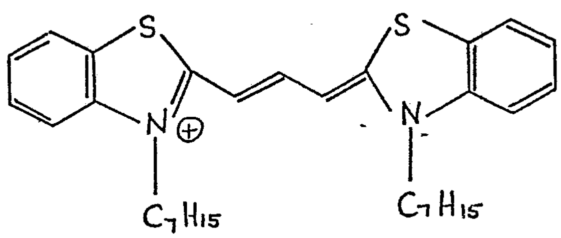 $Ph_3B^{\ominus}n-C_4H_9$ | 568 nm |
| 3. | 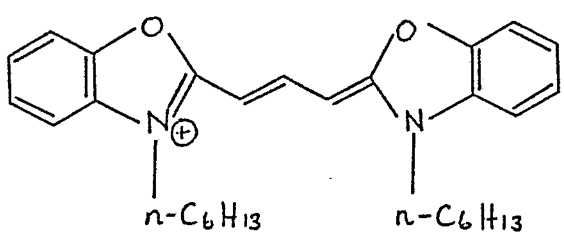 $Ph_3B^{\ominus}n-C_4H_9$ | 492 nm |

4. 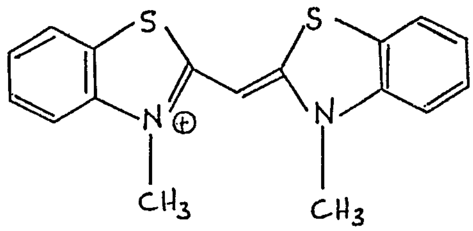 428 nm

$Ph_3B^{\ominus}n-C_4H_9$

5. 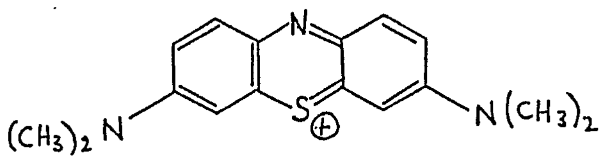 658 nm

$Ph_3B^{\ominus}n-C_4H_9$

6. 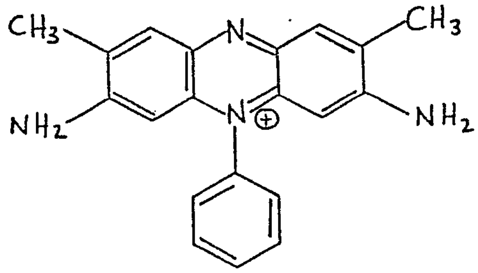 528 nm

$Ph_3B^{\ominus}n-C_4H_9$

7.

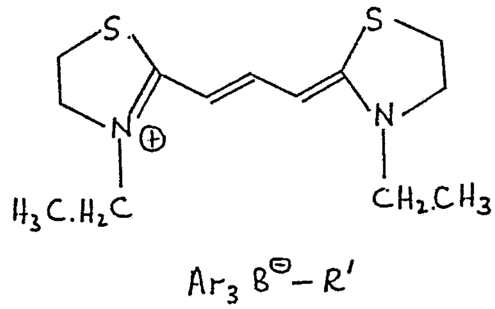

450nm

| No. | R' | Ar |
|---|---|---|
| 7A | n-butyl | phenyl |
| 7B | n-hexyl | phenyl |
| 7C | n-butyl | anisyl |

8.

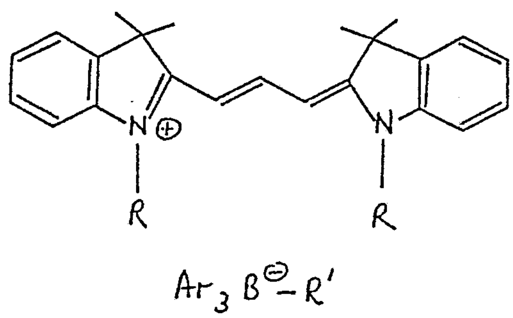

550nm

| No. | R' | R | Ar |
|---|---|---|---|
| 8A | methyl | n-butyl | phenyl |
| 8B | methyl | n-hexyl | phenyl |
| 8C | n-butyl | n-butyl | phenyl |
| 8D | n-butyl | n-hexyl | phenyl |
| 8E | n-heptyl | n-butyl | phenyl |
| 8F | n-heptyl | n-hexyl | phenyl |
| 8G | ethyl | n-butyl | phenyl |

9. 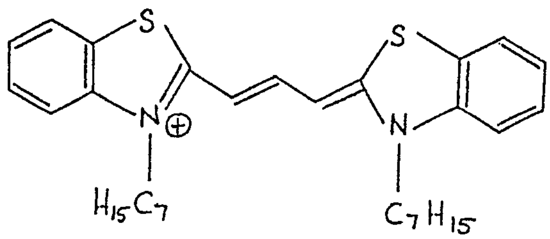 570 nm System

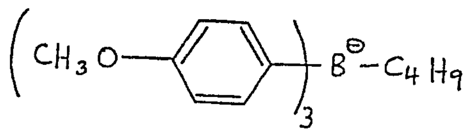

10. 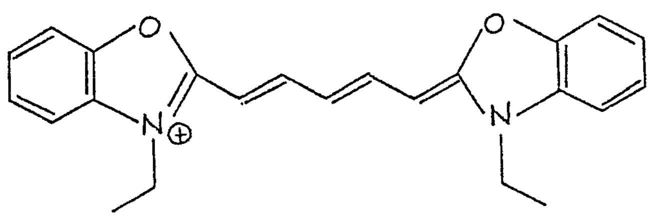 590 nm System

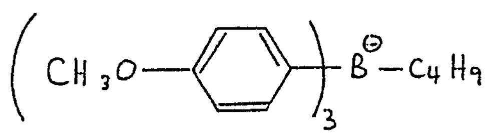

11. 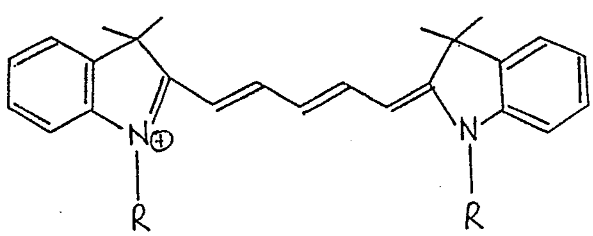 640 nm

$Ar_3 B^{\ominus} - R'$

| No. | R | R' | Ar |
|---|---|---|---|
| 11A | methyl | n-butyl | phenyl |
| 11B | methyl | n-hexyl | phenyl |
| 11C | n-butyl | n-butyl | phenyl |
| 11D | n-butyl | n-hexyl | phenyl |
| 11E | n-pentyl | n-butyl | phenyl |
| 11F | n-pentyl | n-hexyl | phenyl |
| 11G | n-heptyl | n-butyl | phenyl |
| 11H | n-heptyl | n-hexyl | phenyl |
| 11I | methyl | n-butyl | anisyl |

12. 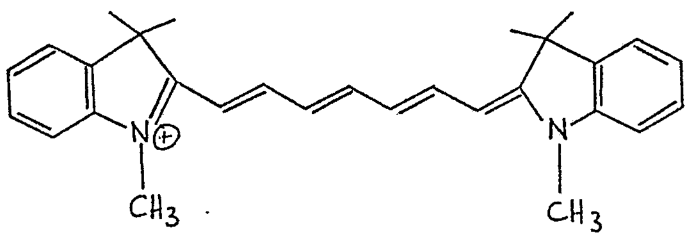 740 nm System

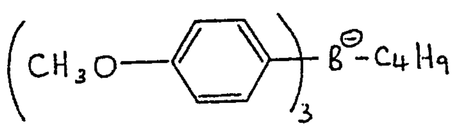

The cationic dye-borate anion compounds can be prepared by reacting a borate salt with a dye in a counter ion exchange in a known manner. See Hishiki, Y., Repts. Sci. Research Inst. (1953), 29, pp 72-79. Useful borate salts are sodium salts such as sodium tetraphenylborate, sodium triphenylbutylborate, sodium trianisylbutylborate and ammonium salts such as tetraethylammonium tetraphenylborate.

Anionic dye compounds are also useful in

$[R^5\text{-I-}R^6]_n$ D-n (IV)

where D− is an anionic dye and $R^5$ and $R^6$ are independently selected from the group consisting of aromatic nucleii such as phenyl or naphthyl and n is 1 or 2; and anionic dye-pyryllium compounds of the formula (V):

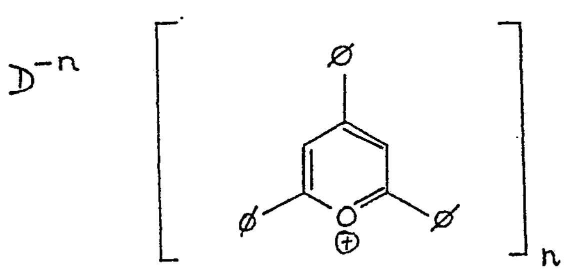 (V)

where D− and n are as defined above are typical examples of anionic dye complexes.

Representative examples of anionic dyes include xanthene and oxonol dyes. For example Rose Bengal, eosin, erythrosin, and fluorscein dyes are useful. In addition to iodonium and pyryllium ions, other compounds of anionic dyes and sulfonium and phosphonium cations are potentially useful.

As in the case of the cationic dye compounds, useful dye-cation combinations can be identified through the Weller equation as having a negative free energy.

Selected examples of anionic dye compounds are shown in Table 2 λ max. ca. 570 nm in TMPTA. In Table 2 the symbol φ is used for a phenyl group and the structure

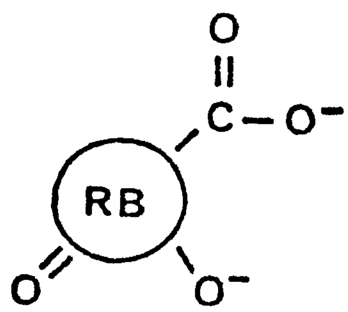

is used for

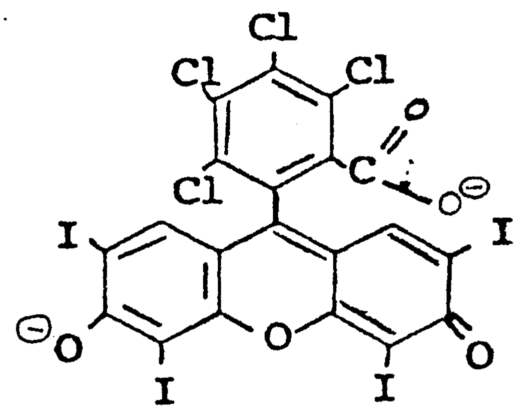

Table 2

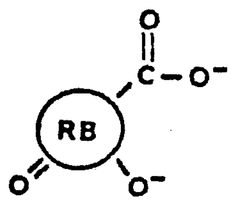

$(\phi_2 I^{\oplus})_2$

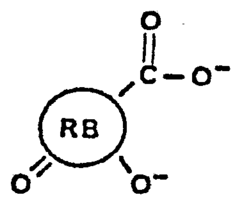

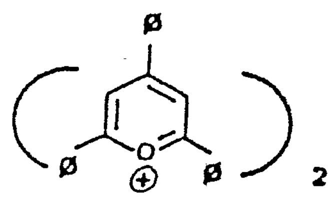

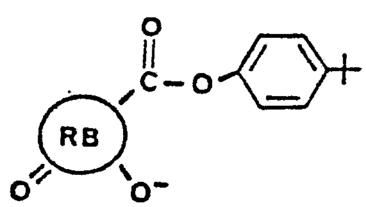

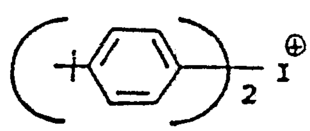

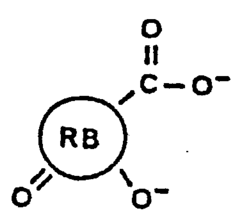

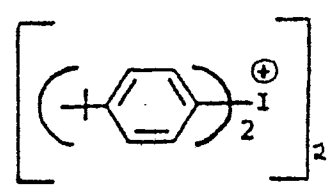

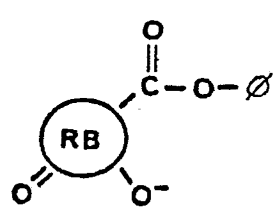

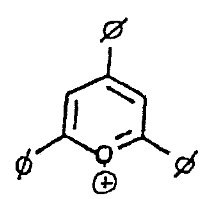

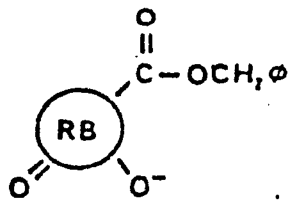

$\phi_2 I^{\oplus}$

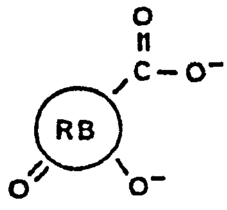

$[\phi_3 \overset{\oplus}{P} CH_2 \phi]_2$

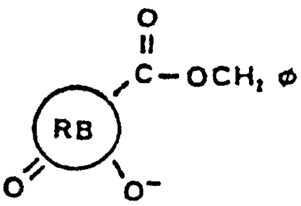

$\phi_3 \overset{\oplus}{P} CH_2 \phi$

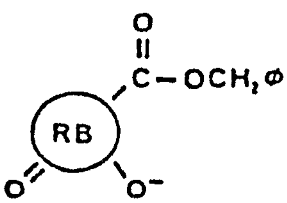

$CH_3 \overset{\oplus}{S} \phi_2$

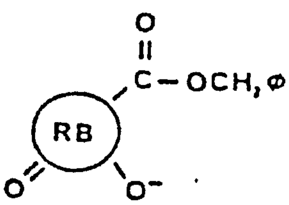

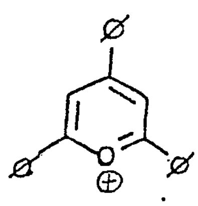

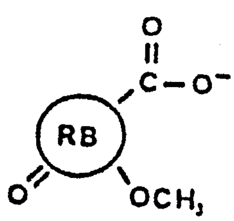

$\phi_2 I^{\oplus}$

The most typical examples of a free radical addition polymerizable or crosslinkable compound useful in practice of the present invention is an ethylenically unsaturated compound and, more specifically, a

polyethylenically unsaturated compound. These compounds include both monomers having one or more ethylenically unsaturated groups, such as vinyl or allyl groups, and polymers having terminal or pendant ethylenic unsaturation. Such compounds are well known in the art and include acrylic and methacrylic esters of polyhydric alcohols such as trimethylolpropane, pentaerythritol, and the like; and acrylate or methacrylate terminated epoxy resins, acrylate or methacrylate terminated polyesters, etc. Representative examples include ethylene glycol diacrylate, ethylene glycol dimethacrylate, trimethylolpropane triacrylate (TMPTA), pentaerythritol tetraacrylate, pentaerythritol tetramethacrylate, dipentaerythritol hydroxypentacrylate (DPHPA), hexanedioll,6-dimethacrylate, and diethyleneglycol dimethacrylate.

The ionic dye compound is usually used in an amount up to about 1% by weight based on the weight of the photopolymerizable or crosslinkable species in the photohardenable composition. More typically, the compound is used in an amount of about 0.2% to 0.5% by weight.

While the compound can be used alone as the initiator, film speeds tend to be quite low and oxygen inhibition is observed. It has been found that it is preferable to use the compound in combination with an autoxidizer. An autoxidizer is a compound which is capable of consuming oxygen in a free radical chain process.

Examples of useful autoxidizers are N,N-dialkylanilines. Examples of preferred N,N-dialkylanilines are dialkylanilines substituted in one or more of the ortho-, meta-, or paraposition by the following groups: methyl, ethyl, isopropyl, t-butyl, 3,4-tetramethylene, phenyl, trifluoromethyl, acetyl, ethoxycarbonyl, carboxy, carboxylate, trimethylsilymethyl, trimethylsilyl, triethylsilyl, trimethylgermanyl, triethylgermanyl, trimethylstannyl, triethylstannyl, n-butoxy, n-pentyloxy, phenoxy, hydroxy, acetyl-oxy, methylthio, ethylthio, isopropylthio, thio-(mercapto-), acetylthio, fluoro, chloro, bromo and iodo.

Representative examples of N,N-dialkylanilines useful in examples of our process are 4-cyano-N, N-dimethylaniline, 4-acetyl-N,N-dimethylaniline, 4-bromo-N, N-dimethylaniline, ethyl 4-(N,N-dimethylamino) benzoate, 3-chloro-N,N-dimethylaniline, 4-chloro-N,N-dimethylaniline, 3-ethoxy-N,N-dimethylaniline, 4-fluoro-N,N-dimethylaniline, 4-methyl-N,N-dimethylaniline, 4-ethoxy-N,N-dimethylaniline, N,N-dimethylthioanicidine, 4-amino-N,N-dimethylaniline, 3-hydroxy-N,N-dimethylaniline, N,N,N',N'-tetramethyl-1,4- dianiline, 4-acetamido-N, N-dimethylaniline, etc.

Preferred N,N-dialkylanilines are substituted with an alkyl group in the ortho-position and include 2,6-diisopropyl-N,N-dimethylaniline, 2,6-diethyl-N,N-dimethylaniline, N,N,2,4,6-pentamethylaniline (PMA) and p-t-butyl-N,N-dimethylaniline.

The autoxidizers are preferably used in concentrations of about 4-5% by weight.

Because the complexes typically absorb at wavelengths greater than 400 nm, they are coloured during the initial exposure to actinic radiation. However, to be fully acceptable, the complex should preferably be bleached essentially transparent with prolonged exposure to visible light or ambient ultraviolet radiation (e.g., sunlight).

The photohardenable compositions of the present can be coated on the first transparent or translucent substrate in a conventional manner. Typical coating means include brushing, spray coating, roll coating, blade coating, etc. The coating thickness is about 1 to 20 microns, with a preferred thickness of 5 to 10 microns.

In some cases it may be desirable to adjust the viscosity of the adhesive to facilitate obtaining a smooth even coating free from entrapped air bubbles or the like. The viscosity of the composition can be adjusted through the addition of inert diluents such as propylene carbonate or through the use of monomer blends.

After coating the photohardenable composition on one surface of a first substrate, a second substrate is applied to the photohardenable composition so that the photohardenable composition is interposed between the first substrate and the second substrate. The three layer structure is then exposed to light.

When complete transparency is desired the dye must be photobleachable, i.e., it must be bleached to an essentially colourless condition upon exposure to visible light or sunlight. Where a tinted effect is desirable, the photobleachability of the dye would not be required. Thus, while the process of the present invention will typically require the use of dye complexes containing photobleachable dyes, it is not limited to this and it is open to the use of non-bleachable complexes in those applications in which transparency is not required.

## Claims

1. A process for laminating two substrates which comprises the steps of:

coating a photohardenable composition on one surface of a first substrate, said photohardenable composition comprising a free radical addition polymerizable or crosslinkable compound and a dye-counter ion complex, said complex being capable of absorbing actinic radiation and producing free radicals which initiate free radical polymerization or crosslinking of said compound;

applying a second substrate to said photohardenable composition to form a laminate in which said photohardenable composition is interposed between said first and said second substrate; and

exposing said laminate to actinic radiation; at least one of said substrates being transparent or translucent.

2. A process according to Claim 1, wherein at least one of said substrates is a transparent or translucent polymeric film.

3. A process for laminating two substrates which comprises the steps of:

coating a photohardenable composition on one surface of a first substrate, said photohardenable composition comprising a free radical addition polymerizable or crosslinkable compound and a dye-counter ion complex, said complex being capable of absorbing actinic radiation and producing free radicals which initiate free radical polymerization or crosslinking of said compound;

applying a second substrate to said photohardenable composition is such that said photohardenable composition is interposed between said first substrate and said second substrate; and

exposing said substrates to actinic radiation; wherein at least one of said substrates is glass.

4. A process according to Claim 3, wherein said first and said second substrates are glass.

5. A process according to any preceding claim, wherein said compound is an ethylenically unsaturated compound.

6. A process according to any preceding claim, wherein said complex is photobleachable.

7. A process according to Claim 6, wherein said complex is a cationic dye-borate anion complex.

8. A process according to Claim 7, wherein said cationic dye-borate anion complex is represented by the formula:

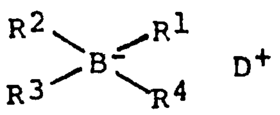

where D+ is a cationic dye moiety and $R^1$, $R^2$, $R^3$ and $R^4$ are the same or different and selected from alkyl, aryl, aralkyl, alkaryl, alkenyl, alkynyl, alicyclic, heterocyclic, and allyl groups.

9. A process according to claim 8, wherein said cationic dye is selected from cationic methine, polymethine, triarylmethane, indoline, thiazine, xanthene, oxazine, and acridine dyes.

10. A process according to Claim 6, wherein said complex is an anionic dye complex.

11. A process according to Claim 10, wherein said anionic dye is selected from the group consisting of xanthene and oxonol dyes.

12. A process according to Claim 11, wherein said complex is an anionic dye-iodonium ion complex or an anionic dye-pyryllium ion complex.